# EUROPEAN PATENT APPLICATION

(11) **EP 2 757 866 A1**
(43) Date of publication of application: **23.07.2014**
(21) Application number: 13151930.8
(22) Date of filing: 18.01.2013
(51) Int. Cl.: H05K 7/20, H05K 5/02

(54) **Display device and television device**

(71) Applicant: Funai Electric Co., Ltd., Daito-shi Osaka 574-0013 (JP)
(72) Inventor: Suzuki, Yuto, Osaka, Osaka 574-0013 (JP); Nitanai, Naoki, Osaka, Osaka 574-0013 (JP)
(74) Representative: Giovannini, Francesca

(57) **Abstract**

A display device (100) including a display part (2), a light emitting element (6a) adapted to shine light into the display part (2), a light emitting element board (6b) with the light emitting element (6a) fixed on one side, a heat dissipating material (10) formed by bending a sheet material made of metal so as to include a first plane attached to an other side of the light emitting element board (6b) and a second plane that forms a specified angle with respect to the first plane and has a heat dissipation function to dissipate heat from the light emitting element (6a). The heat dissipating material (10) includes a release part (10k) formed by removing a bended part (10g) that is the boundary of the first plane and the second plane. The display device (100) also includes a board supporting part (10n) formed in an area corresponding to the release part (10k) in the second plane.

## Description

### Field of the Invention

The present invention relates generally to a display device and television device provided with a heat dissipating material formed by bending of a sheet-shaped material made of metal.

### Background of the Invention

In the past, display devices with heat dissipating materials formed by bending sheet-shaped material made of metal have been known (see for example Cited Patent Document 1).

The aforementioned Cited Patent Document 1 discloses a liquid crystal display device comprising a liquid crystal panel (display part) and a circuit board (light emitting element board) having one side whereupon is mounted a LED (a light emitting element) illuminating the liquid crystal panel and a rear side frame (heat dissipating material) having an inner surface retaining the liquid crystal panel and circuit board. In such a liquid crystal display device, the rear side frame is formed by bending a metal sheet of aluminum. Specifically, the inner surface of the rear side frame is shaped so as to contain a first plane mounted on another surface on the side opposite the LED on the circuit board, and a second plane approximately perpendicular to the first plane, and a bended area at the boundary area of the first and second planes. Also, the other surface of the circuit board on the side opposite the LED is attached to the first plane in a state whereby the second plane of the rear side frame and the end plane on the second-plane side of the rear side frame on the circuit board are in contact. Here, normally the bended area formed by means of a process of bending a metal sheet of aluminum etc. is formed so as to have an inner surface in the shape of a curve.

### Patent Documents

Cited Patent Document 1: Patent Laid-open 2006-267936

However, in a liquid crystal display device as disclosed in the aforementioned Cited Patent Document 1, when attaching the first plane of the rear side frame to the other surface of the circuit board while causing contact between the second plane of the rear side frame (heat dissipating material) and the end surface of the second plane side of the rear side frame of the circuit board (light emitting element board), in some cases the end surface of the second plane of the rear side frame of the circuit board comes into contact with the inner surface of the curved part of the bended part of the rear side frame. In such cases, the circuit board becomes fixed in an inclined position diagonally with respect to the first plane of the rear side frame, due to the curved shape of the inner surface of the bended part of the rear side frame. For this reason, light from the LED (light source) mounted on one surface of the circuit board is emitted in a diagonal direction with respect to the direction of illumination (perpendicular with respect to the first plane of the rear side frame), with the result that the amount of light illuminating the liquid crystal panel (display part) is reduced.

One or more embodiments of the present invention provide a display device and television device capable of preventing reduction of light illuminating the display part.

### Summary of the Invention

In one aspect, a display device according to one or more embodiments of the present invention includes: a display part; a light emitting element adapted to shine light into the display part; a light emitting element board with the light emitting element fixed on one side; a heat dissipating material formed by bending a sheet material made of metal so as to include: a first plane attached to an other side of the light emitting element board, and a second plane that forms a specified angle with respect to the first plane and has a heat dissipation function to dissipate heat from the light emitting element. The heat dissipating material includes a release part formed by removing a bended part that is the boundary of the first plane and the second plane. The display device also includes a board supporting part formed in an area corresponding to the release part in the second plane and protruding toward the light emitting element board so as to contact the light emitting element board.

According to one or more embodiments, when the other side of the light emitting element board is attached to the first plane of the heat dissipating material, it is possible to cause contact between the board supporting part(s) on the second plane of the heat dissipating material and the end(s) of the light emitting element board on the side of the second plane of the heat dissipating material, and thereby affix the light emitting element board so that the bended part of the heat dissipating material and the light emitting element board do not contact each other. As a result thereof, it is possible to prevent affixing of the light emitting element board in an inclined position diagonally with respect to the first plane on the heat dissipating material. And further as a result thereof, it is possible to prevent light from the light emitting element from shining in a direction that deviates from the intended direction of illumination of light (a direction perpendicular to the first plane of the heat dissipating material), and thus it is possible to prevent reduction in the amount of light shining into the display part.

According to one or more embodiments, a cutout part may be formed by forming hole part(s) in at least one plane of the heat dissipating material and removing one part of the bended part. By means of this construction, the cutout part(s) can be formed easily, simply by forming hole part(s) in at least one plane of the heat dissipating material and removing one part of the bended part.

According to one or more embodiments, the board supporting part may be formed in a flat shape, contacting the light emitting element board and positioned in an area corresponding to the hole part(s) protruding on the side of the light emitting element board farther than the second plane positioned in other areas than areas corresponding to the hole part. By this means, it is possible to cause the board supporting part(s) formed in a flat shape, and the end surfaces of the light emitting element board on the second plane side of the heat dissipating material to come into contact, and as a result it is possible to support the light emitting element board in a more stable manner.

According to one or more embodiments, the heat dissipating material may further include a pair of cutout parts placed in the second plane so as to extend from the two ends of the hole part(s) along a direction perpendicular to the direction in which the light emitting board extends, and the board supporting part(s) may be formed by means of causing the second plane, positioned in an area enclosed by the hole part(s) and pair of cutout parts, to protrude on the side of the light emitting board. By means of such a configuration, the board supporting part is surrounded by the hole part(s) and pair of cutout parts, and therefore it is possible to easily fabricate the board supporting part(s) so as to protrude on the side of the light emitting element board.

According to one or more embodiments, the length of the board supporting part(s) in the direction in which the light emitting element board extends may be greater than the length of one light emitting element in the direction in which the light emitting element board extends. By means of such a configuration, it is possible to support the light emitting element board in stable fashion by means of board supporting part(s) whereby the length thereof is greater than in the direction in which the light emitting board extends is greater than one light emitting element, and thus it is possible to prevent slanting of the part of the light emitting element board supported by the board support part, and thereby it is possible to prevent reduction of the amount of light entering the display part.

According to one or more embodiments, a heat dissipating tape is further provided, being placed between the other surface of the light emitting element board and the first plane of the heat dissipating material, and having a heat dissipating function and a bonding function for the purpose of attaching the other surface of the light emitting element board to the first plane of the heat dissipating material by means of bonding. By means of such a configuration, it is possible to dissipate heat conducted from light emitting elements through the light emitting element board, while also bonding the other surface of the light emitting element board and the first plane of the heat dissipating material.

According to one or more embodiments, a claw part(s) may be placed in the end of the part(s) corresponding to the cutout part(s) of the first plane on the opposite side of the second plane and extending to the side of the light emitting element board, and the claw part(s) and light emitting element board may be separated by a designated distance. By means of such a configuration, it is possible to prevent the light emitting element board from moving away from the heat dissipating material by means of the claw part(s). Also, by placing a designated distance separating the claw part(s) and light emitting element board it is possible to prevent the light emitting element board from contacting the curved area between the claw part(s) and the first plane. By this means it is possible to prevent the light emitting element board from becoming affixed in a direction slanted with respect to the first surface, due to contact between the light emitting element board and the curved area between the claw and the first plane. As a result, it is possible to prevent light from the light emitting elements from being emitted in a direction apart from the originally intended direction of emission, and thereby it is possible to prevent reduction of the amount of light entering the display part.

According to one or more embodiments, a multiplicity of board supporting parts are placed at designated intervals along the direction in which the light emitting element board extends. By means of such a configuration, it is possible to support the light emitting element board in a more stable manner while preventing the light emitting element board from contacting the bended part between the first and second plane.

In another aspect, a television device according to one or more embodiments of the present invention includes: a receiving part that receives television broadcasts; a display part that displays television broadcasts received by the receiving part; a light emitting element that shines light into the display part; a light emitting element board with the light emitting element fixed on one side; a heat dissipating material formed by bending a sheet material made of metal so as to include: a first plane attached to an other side of the light emitting element board and a second plane that forms a specified angle with respect to the first plane and has a heat dissipation function to dissipate heat from the light emitting element. The heat dissipating material includes a release part formed by removing a bended part that is the boundary of the first plane and the second plane. The television device also includes a board supporting part formed in an area corresponding to the release part in the second plane and protruding toward the light emitting element board so as to contact the light emitting element board.

According to one or more embodiments, the heat dissipating material is configured so as to include a cutout part(s) formed by removal from the bended part that is the boundary between the first plane and second plane, and the board supporting part(s) is formed in an area corresponding to the cutout part(s) in the second plane, contacting the light emitting element board, protruding on the side of the light emitting element board farther than other areas than the area corresponding to the cutout part in the second plane. By this means, by causing contact of the board supporting part(s) of the second plane of the heat dissipating material and the end of the light emitting element board on the side of the second plane of the heat dissipating material, when attaching the other surface of the light emitting element board to the first plane of the heat dissipating material, it is possible to affix the light emitting element board to the heat dissipating material without allowing contact between the bended part of the heat dissipating material and the light emitting element board.

According to one or more embodiments, it is possible to prevent reduction in the amount of light entering a display part.

### Brief Description of the Drawings

Figure 1 is a perspective view of a liquid crystal television device according to one embodiment of the present invention, viewed from the front side.
Figure 2 is a perspective view of a liquid crystal television device according to one embodiment of the present invention, viewed from the rear side.
Figure 3 is a rear view of a liquid crystal television device according to one embodiment of the present invention.
Figure 4 is an exploded perspective view of a liquid crystal television device according to one embodiment of the present invention.
Figure 5 is a block diagram of a liquid crystal television device according to one embodiment of the present invention.
Figure 6 is an exploded perspective view showing a fold plate and heat sink of a liquid crystal television device according to one embodiment of the present invention.
Figure 7 is an exploded perspective view showing a heat sink, heat dissipating tape, and LED board of a liquid crystal television device according to one embodiment of the present invention.
Figure 8 is an exploded perspective view showing an enlargement of a heat sink and LED board of a liquid crystal television device according to one embodiment of the present invention.
Figure 9 is a perspective view showing an enlargement of a state whereby an LED board is attached to a heat sink of a liquid crystal television device according to one embodiment of the present invention.
Figure 10 is a cross sectional view of Figure 9 along line 200-200.
Figure 11 is a cross sectional view of Figure 9 along line 300-300.

### Detailed Description of Embodiments of the Invention

Embodiments of the present invention will be described below with reference to the drawings.

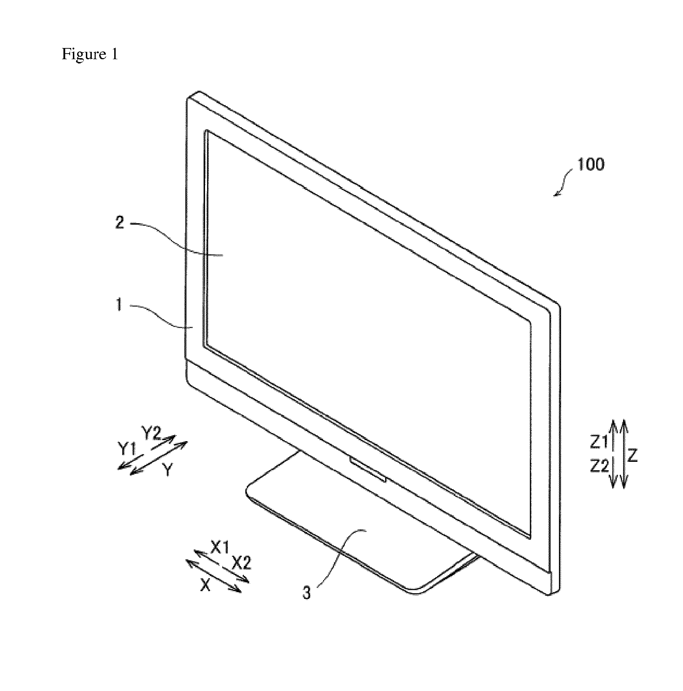

The configuration of a liquid crystal television 100 according to one embodiment of the present invention will be described with reference to Figures 1 through 11. The liquid crystal television 100 is one example of a "display device" according to the present invention, as well as one example of a "television device" according to the present invention.

As shown in Figure 1 through Figure 4, liquid crystal television device 100 is comprised of a front chassis 1 formed in a frame shape and having an approximately rectangular shape viewed from the front (the side in the direction of arrow Y1), and a liquid crystal display panel 2 enclosed within the rear panel side of front chassis 1 (the side in the direction of arrow Y2), and a stand material 3 supporting the entirety of liquid crystal television device 100. The front chassis 1 and stand material 3 are both made of plastic resin. Also, liquid crystal display panel 2 is one example of a "display part" according to the present invention.

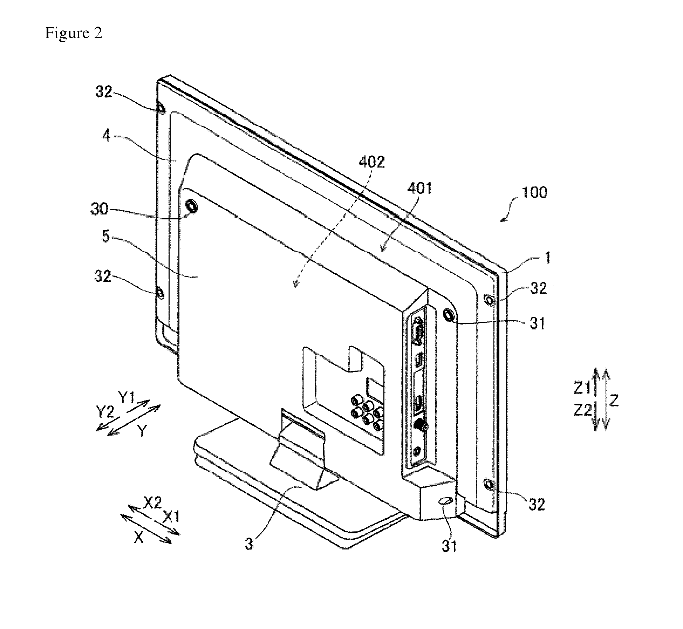

Also, as shown in Figure 2 through Figure 4, a panel supporting material (rear frame) 4 is placed at the rear side of front chassis 1 (the side in the direction of arrow Y2), and one part of the rear surface (the outer peripheral part) thereof forms a rear chassis. The panel supporting material 4 is provided for the purpose of supporting liquid crystal display panel 2. The panel supporting material 4 is formed of a plate shaped material made of metal (SECC: Steel, Electrically Chromate Coated).

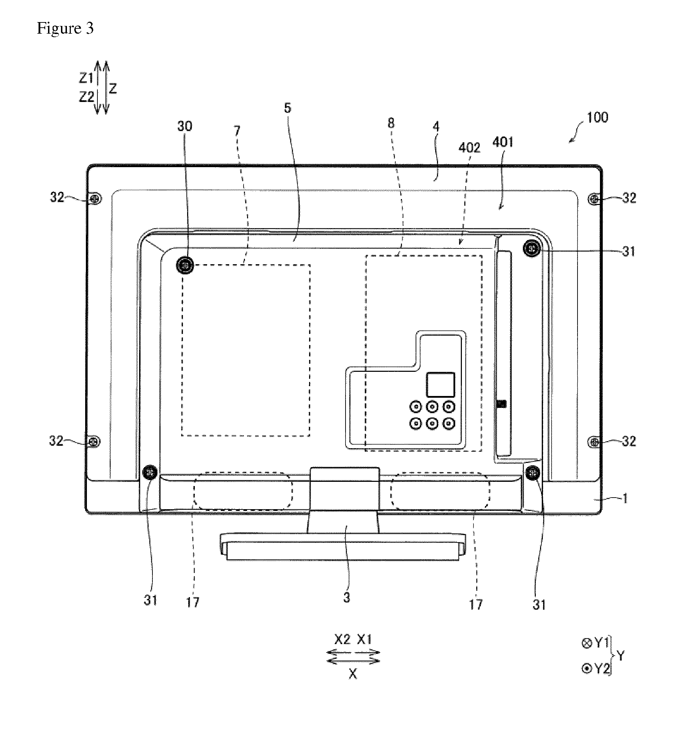

Also, as shown in Figure 2 through Figure 4, a cover material 5 of plastic resin is attached to the rear panel side of panel supporting material 4 (the side in the direction of arrow Y2). As shown in Figure 3, the cover material 5 is formed so as to have an approximately rectangular shape smaller than front chassis 1 and panel supporting material 4 when viewed from the rear side. By this means, cover material 5 is configured so as to expose the peripheral vicinity of the rear surface (the side in the direction of arrow Y2) of panel supporting material 4 in an inverse U shape, while also covering the rear surface of panel supporting material 4. An area 401 exposed by the inverse U shape of the rear surface of panel supporting material 4 has the function of externally dissipating heat generated by LEDs (Light Emitting Diode) 6a described below in the interior of liquid crystal television device 100. The LEDs 6a are one example of a "light emitting element" in the present invention.

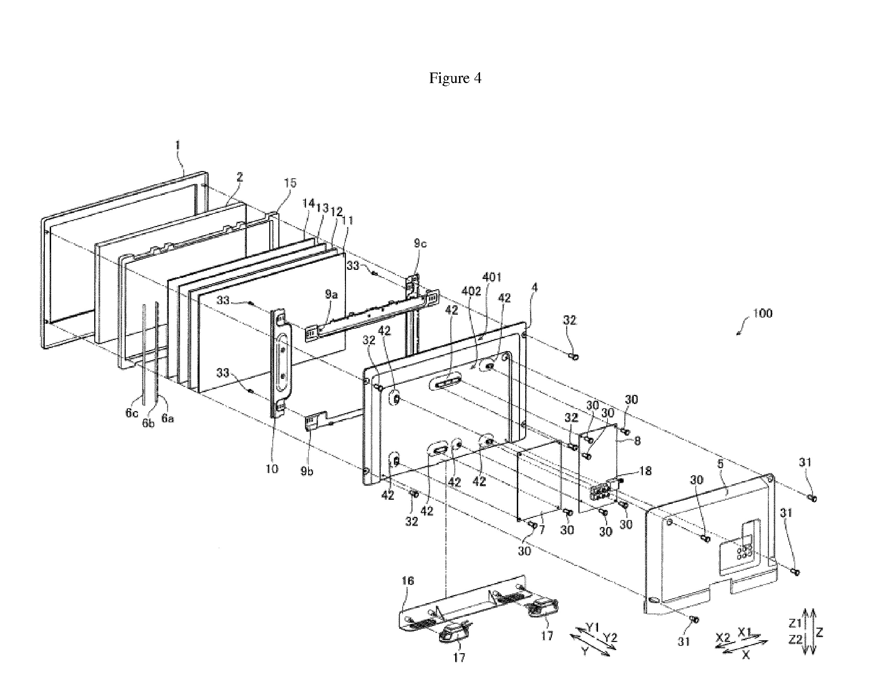

In addition, as shown in Figure 3 and Figure 4, a power supply board 7 and a signal processing board 8 containing a tuner 18, as well as two speakers 17, are placed in an area 402 covered by cover material 5 in the vicinity of the center of the rear surface (the side in the direction of arrow Y2) of panel supporting material 4. The tuner 18 is one example of a "receiving part" in the present invention.

As shown in Figure 3, power supply board 7 and signal processing board 8 are placed in a left-right orientation (the X direction) in area 402 in the vicinity of the center of the rear surface (the side in the direction of arrow Y2) of panel supporting material 4. Also, the two speakers 17 are placed on a speaker mounting material 16 (see Figure 4) below power supply board 7 and signal processing board 8, along a left-to right orientation (the side in the direction of arrow Z2).

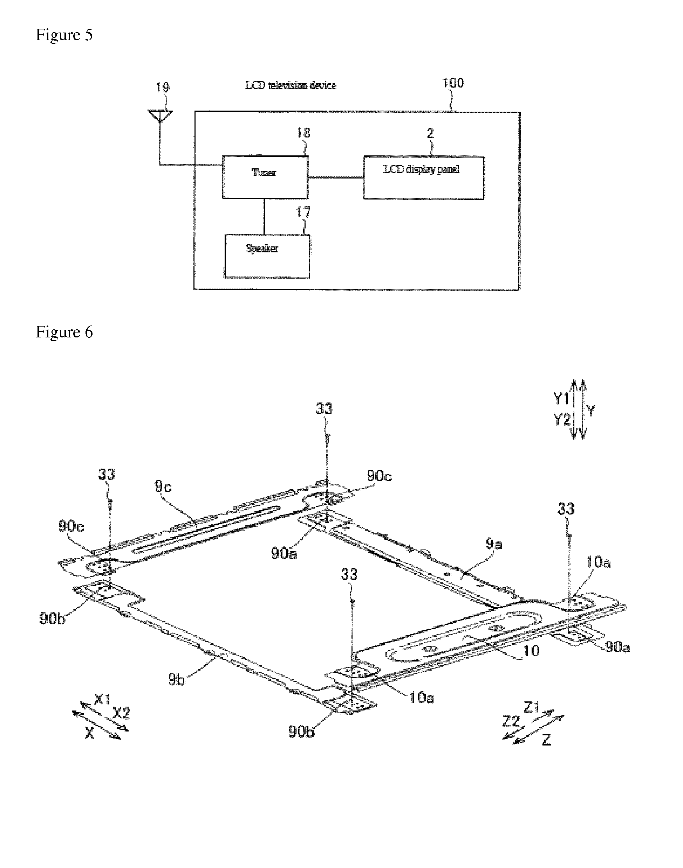

Power supply board 7 is provided for the purpose of supplying power to the entirety of liquid crystal television device 100. Also, signal processing board 8 is provided for the purpose of performing signal processing of television broadcast video signals and audio signals received by means of tuner 18. Here, as shown in Figure 5, tuner 18 on signal processing board 8 is connected to antenna 19 for receiving television broadcasts, as well as to liquid crystal display panel 2 and speakers 17. By this means, signal processing board 8 is configured so as to take video signals and audio signals of television broadcasts received by tuner 18 through antenna 19, and output the video signals to liquid crystal display panel 2 and audio signals to speakers 17.

As shown in Figure 4, power supply board 7 and signal processing board 8 are attached by means of screw parts 30 to board mounting part 42 provided the vicinity of the center of the rear surface (the side in the direction of arrow Y2) of panel supporting material 4. Also, cover material 5 is attached by means of screw parts 30 and 31 to area 402 in the vicinity of the center of the rear surface of panel supporting material 4. And in addition, front chassis 1 is attached by screw parts 32 to area 401 exposed in an inverse U shape in the vicinity of the center of the rear surface (the side in the direction of arrow Y2) of panel supporting material 4.

As shown in Figure 4, three holding plates 9a, 9b, and 9c formed of plate shaped material made of metal (SECC) with thickness approximately 0.6mm, and one heat sink 10 of plate shaped material of metal (sheet metal of aluminum or aluminum alloy having superior heat dissipation capacity) of thickness approximately 1.0mm are placed on the rear side (the side in the direction of arrow Y2) of liquid crystal display panel 2, and also on the front side (the side in the direction of arrow Y1) of panel supporting material 4. Also, on the front side of holding plates 9a through 9c and heat sink 10, a reflective sheet 11, light conductive plate 12, light dissipating plate 13, lens sheet 14, frame-shaped resin frame 15, liquid crystal display panel 2, as well as a bezel etc. not pictured, are placed as layers in that order. The heat sink 10 is one example of a "heat dissipating material" in the present invention, and also one example of a "plate shaped material" in the present invention.

As shown in Figure 4, holding plates 9a, 9b, 9c and heat sink 10 are placed respectively on the outer periphery side of aforementioned chassis 1 (the side in the direction of arrow Z1, the side in the direction of arrow Z2, the side in the direction of arrow X1, and the side in the direction of arrow X2). In addition, as shown in Figure 4 and Figure 6, holding plates 9a and 9b are both formed so as to extend in the left-right direction (X direction). And also, holding plate 9c and heat sink 10 are both formed so as to extend in the up-down direction (Z direction).

A pair of screw holes 90a and 90b matching screw materials 33 are placed at both ends of the long direction (X direction) of both holding plates 9a and 9b, as shown in Figure 6. Also, a pair of screw insertion holes 90c corresponding respectively to screw holes 90a and 90b placed at the ends of holding plates 9a and 9b on the side of the direction of arrow X1 are placed at both ends of the long sides of holding plate 9c (Z direction). In the same manner, a pair of screw insertion holes 10a are placed corresponding respectively to screw holes 90a and 90b placed at the ends of holding plates 9a and 9b on the side of the direction of arrow X2 at both ends of the long direction (Z direction) of heat sink 10. By this means, holding plates 9a through 9c, and heat sink 10, are fixed (bolted) together by means of screw materials 33. As a result, an approximately rectangular frame is constructed so as to hold and support reflective sheet 11 etc. (see Figure 4) stacked on the front side (the side in the direction of arrow Y1) of holding plates 9a through 9c and heat sink 10, by one side of the front chassis 1 (the side in the direction of arrow Y1).

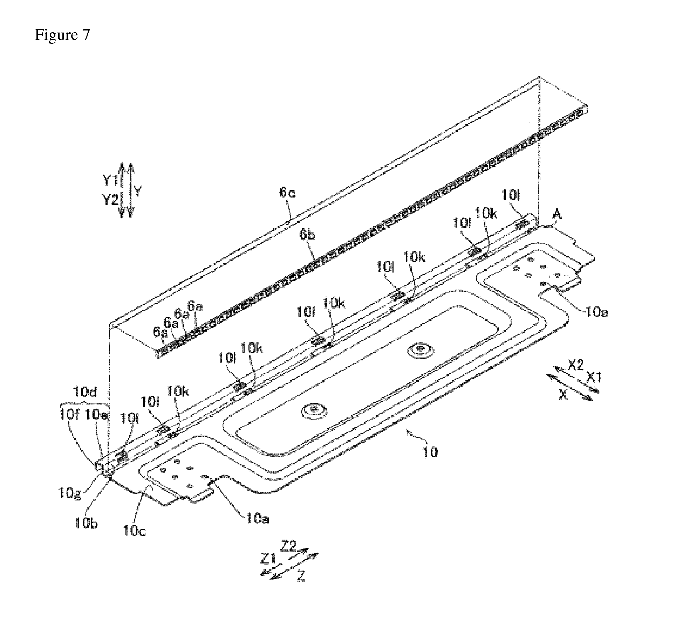

As shown in Figure 4, LED board 6b whereupon a multiplicity of LEDs 6a for backlighting are mounted (affixed) is placed on the front side of heat sink 10 (the side of the direction of arrow Y1) and the side of light conductive panel 12 (the side of the direction of arrow X2). The LED board 6b is one example of a "light emitting board" in the present invention. As shown in Figure 4 and Figure 7, LED board 6b is formed so as to extend in the long direction (the Z direction) of heat sink 10. Also, as shown in Figure 7, the multiplicity of LEDs 6a are mounted on one surface of LED board 6b (the surface on the side of arrow X1), at designated intervals along the direction where LED board 6b extends (the Z direction).

In the present embodiment, as shown in Figure 7 through Figure 11, heat sink 10 is configured so as to contain a side part 10b having an inner side (the surface in the direction of arrow X1) whereupon the other surface of LED board 6b (the surface on the side of the direction of arrow X2) is mounted, and a bottom part 10c supporting reflective sheet 11 etc., and heat dissipating part 10d extending along the opposite side of LED board 6b (the side in the direction of arrow X2) from the end of the opposite sides of side part 10b and bottom part 10c (the side in the direction of arrow Y1). The inner side of side part 10b (the plane on the side of the direction of arrow X1) is one example of a "first plane" in the present invention. Also, the surface of bottom part 10c on the side of LED board 6b (the plane on the side of the direction of arrow Y1) is one example of a "second plane" in the present invention.

As shown in Figure 7 through Figure 11, side part 10b is formed so as to extend along a plane parallel to LED board 6b (the Y-Z plane). Also, bottom part 10c is formed so as to extend along a plane perpendicular to LED board 6b (the X-Z plane). And heat dissipating material 10d is formed so as to contain a first part 10e extending along a plane perpendicular to LED board 6b, and a second part 10f extending along a plane parallel to LED board 6b.

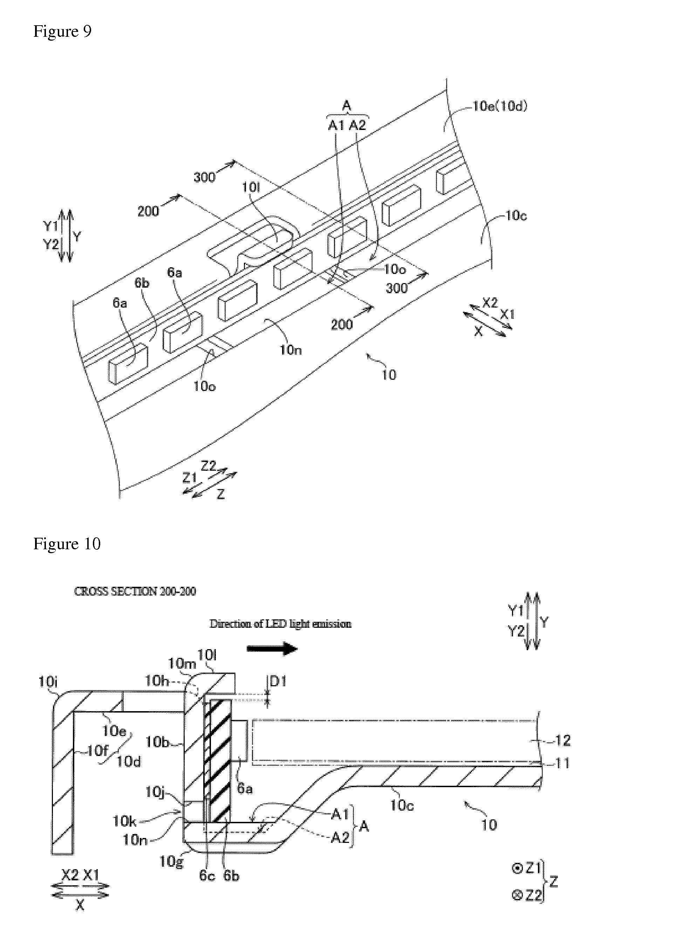

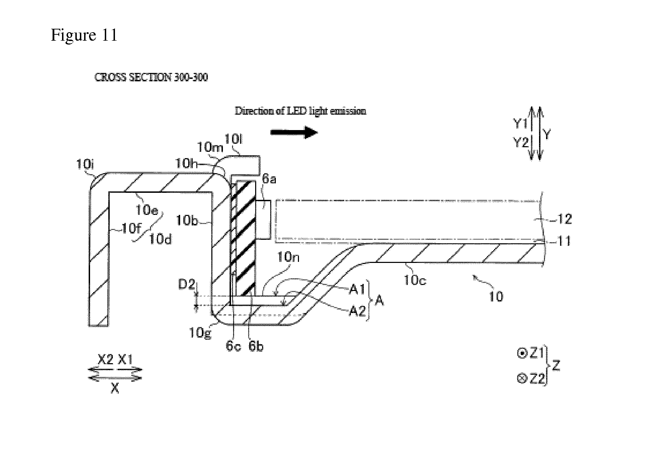

Side part 10b, bottom part 10c, and heat dissipating part 10d are formed together as one unit by bending in a press process etc. a sheet material made of metal (sheet metal comprised of aluminum or aluminum alloy with superior heat dissipation properties). By this means, as shown in Figure 10 and Figure 11, side part 10b is formed so as to rise in perpendicular fashion (the direction of arrow Y1) from the ends of bottom part 10c on the side of the direction of arrow X2. Also, at the boundary between side part 10b and bottom part 10c, bended part 10g is formed contacting side part 10b and bottom part 10c. In similar fashion, bended parts 10h and 10i are formed respectively, at the boundary between side part 10b and heat dissipating part 10d, and at the boundary between first part 10e and second part 10f of heat dissipating material 10d. Each of the bended parts 10g through 10i respectively has inner surfaces curved so as to have a specified radius of curvature. The bended part 10g is one example of a "bended part" in the present invention.

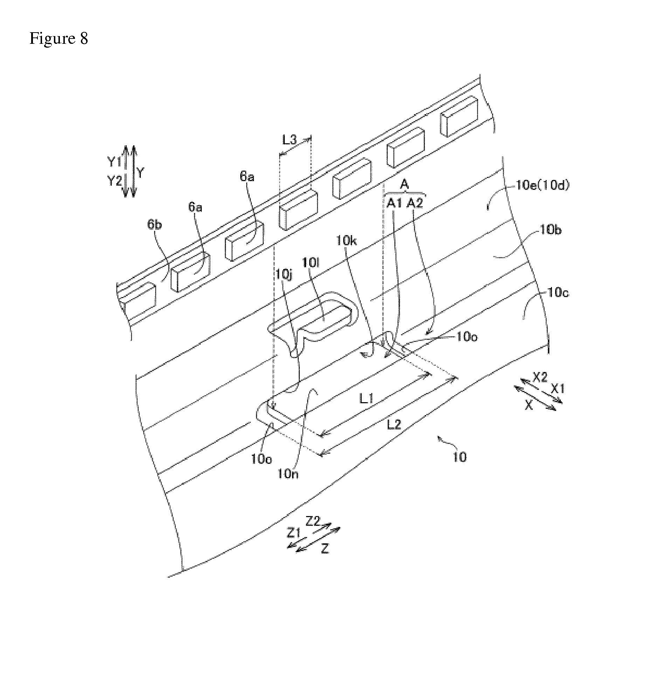

In addition, as shown in Figure 7 and Figure 8, heat sink 10 is constructed so as to contain release parts 10k shaped by removing a part of bended part 10g, whereby holes 10j are formed in side part 10b. As shown in Figure 7, 5 release parts 10k are placed at designated intervals along the direction in which LED board 6b extends (the Z direction). Also, as shown in Figure 8, hole parts 10j are placed in the ends of side part 10b on the bottom part 10c side (the side of the direction of arrow Y2), so as to extend along the direction in which LED board 6b extends (the Z direction).

Also, as shown in Figure 7 through Figure 9, heat sink 10 is configured to include claw parts 10*l* extending from the end of side part 10b opposite bottom part 10c (the side of the direction of arrow Y1) and extending to the side of LED board 6b (the side of the direction of arrow X1). As shown in Figure 7, claw parts 10*l* are placed, one each, respectively, near both ends of heat sink 10 in the long direction (the Z direction), and in parts corresponding to the aforementioned 5 release parts 10k. Specifically, seven claw parts 10*l* are placed at specified intervals along the Z direction at the ends of side part 10b opposite bottom part 10c.

In addition, as shown in Figure 7 through Figure 10, claw parts 10*l* are formed by bending whereby the vicinity of the end of first part 10e of heat dissipating part 10d being towards the side of side part 10b (the side in the direction of arrow X1) is bent towards the cut-out side of LED board 6b (the side of the direction of arrow X1). By this means, as shown in Figure 10, bended parts 10m having a curved inner surface is formed at the boundary between claw parts 10*l* and side part lOb. The claw parts 10*l* and the ends of LED board 6b opposite bottom part 10 c (the side in the direction of arrow Y1) are configured so as to be separated by no more than a designated distance D1 in the Y direction when LED board 6b is attached to side part 10b.

Further, as shown in Figure 7 through Figure 11, area A in the vicinity of the end of bottom part 10c on the side of side part 10b (the side in the direction of arrow X2) is configured, so as to be recessed, on the side opposite LED board 6b (the side of the direction of arrow Y2). Here, as shown in Figure 8 and Figure 9, board supporting parts 10n, each having the shape of a flat surface, are provided in area A1, the part within area A of bottom part 10c corresponding to release part 10k, so as to project towards the side of LED board 6b (the side in the direction of arrow Y1) by a designated distance D2 (see Figure 11) farther than the remaining area A2 other than area A1. The board supporting parts 10n are formed so as to extend up to directly below hole parts 10j that comprise release parts 10k.

As shown in Figure 8 through Figure 11, board supporting parts 10n are formed by bottom part 10c, are placed at area A1, and are surrounded by hole parts 10j provided in side part b in the end parts on the side of bottom part 10c (the side in the direction of arrow Y2), and by pair of cutout parts 10o extending from both ends of hole parts 10j in a direction (the X direction) intersecting with the direction (the Z direction) in which LED board 6b extends. As shown in Figure 8, length L1 of board supporting parts 10n in the Z direction is formed so as to be less then length L2 of hole parts 10j along the Z direction. Also, length L1 of board supporting parts 10n in the Z direction is formed so as to be greater than length L3 of one LED 6a along the Z direction.

As shown in Figure 10 and Figure 11, board supporting parts 10n (area A1) are configured so as to support LED board 6b by contacting bottom part 10c of LED board 6b (the side in the direction of arrow Y2) when LED board 6b is attached to side part 10b. As shown in Figure 10, the end(s) of board supporting parts 10n in the direction of arrow X2 are formed so as to form approximately one plane with the surface of side part 10b on the opposite side of LED board 6b (the side in the direction of arrow X2). Also, as shown in Figure 11, the part of bottom part 10c other than board supporting parts 10n (area A2) is configured so as to separated by a specified distance D2 (for example approximately 0.2mm) from the end of LED board 6b toward bottom part 10c, when LED board 6b is attached to side part 10b

Also, as shown in Figure 7, Figure 10, and Figure 11, between the other surface of LED board 6b (the surface on the side in the direction of arrow X2) and side part 10b is placed heat dissipating tape 6c, having a heat dissipation function and an adhesive function for the purpose of bonding the other surface of LED board 6b to side part 10b. Heat dissipating tape 6c is configured as a two-sided tape having superior adhesive properties and heat dissipation properties. By this means, heat generated by emission of light from LEDs 6a is transmitted through LED board 6b, heat dissipating tape 6c and side part 10b to heat dissipating part 10d, and then the head is dissipated through area 401 (see Figure 3) exposed by the inverted U shape of the rear side of panel supporting material 4, to the exterior of liquid crystal television device 100. Also, light irradiated from LEDs 6a is emitted in a direction perpendicular to side part 10b (the direction of arrow X1), and then goes through reflective sheet 11 and light conductive panel 12 and is irradiated into liquid crystal display panel 2.

In the present embodiment, as described above, heat sink 10 is configured so as to contain release parts 10k shaped by removing bended part 10g, and board supporting parts 10n are shaped so as to contact LED board 6b and protrude on the side of LED board 6b (the side in the direction of arrow Y1) more than other areas A2 other than area A1, and so as to correspond to release parts 10k of bottom part 10c in area A. By this means, if the other surface of LED board 6b is attached to side part 10b of heat sink 10, then board supporting parts 10n of bottom part 10c of heat sink 10 are in contact with the end of LED board 6b on the side of bottom part 10c of heat sink 10 (the side in the direction of arrow Y2), and thereby it is possible to affix LED board 6b to heat sink 10 without causing contact between LED board 6b and bended part 10g of heat sink 10. As a result, it is possible to prevent affixing of LED board 6b in a diagonal position with respect to side part 10b of heat sink 10. And thereby, it is possible to prevent a state in which light of LEDs 6a is irradiated in directions other than the intended direction of emission (a direction perpendicular to side part 10b of heat sink 10 (the direction of arrow X1)), and thereby to prevent reduction of the amount of light irradiated into liquid crystal display panel 2.

Also, in the present embodiment, hole parts 10j are formed in bottom part 10b of heat sink 10, and release parts 10k are formed by removal of a part of bended part 10g. By this means, it is possible to easily form release parts 10k simply by forming hole parts 10j in side part 10b of heat sink 10 and removing a part of bended part 10g.

Also, in the present embodiment, as described above, board supporting parts 10n are provided in an area (area A1 of bottom part 10c) corresponding to hole parts 10j, and also are formed in a flat shape contacting LED board 6b and protruding on the side of LED board 6b (the side in the direction of arrow Y1) further than bottom part 10c positioned in other areas than the area corresponding to hole parts 10j (area A2 of bottom part 10c). By this means it is possible to cause planar contact between board supporting parts 10n formed in a flat shape, and the ends of LED board 6b on the side of bottom part 10c of heat sink 10, and thereby it is possible to support LED board 6b in a more stable manner.

Also, in the present embodiment, as described above, a pair of cutout parts 10o are provided in bottom part 10c of heat sink 10, extending from both ends of hole parts 10j along a direction (the X direction) intersecting the direction (Z direction) wherein LED board 6b extends, and board supporting parts 10n are formed by causing bottom part 10c positioned in area A1 enclosed by hole parts 10j and the pair of cutout parts 10o to protrude on the side of LED board 6b (the side in the direction of arrow Y1). By this means, board supporting parts 10n are enclosed by hole parts 10j and the pair of cutout parts 10o, and therefore it is possible to easily fabricate board supporting parts 10n protruding on the side of LED board 6b.

In addition, in the present embodiment, as described above, length L1 of board supporting parts 10n along the direction in which LED board 6b extends (the Z direction) is made longer than length L3 of one LED 6a along the direction in which LED board 6b extends. By this means, it is possible to support LED board 6b in a more stable manner by means of board supporting parts 10n having length greater than one LED 6a in the direction in which LED board 6b extends, and as a result, it is possible to prevent slanting of parts of LED board 6b supported by board supporting parts 10n, and further as a result it is possible to thereby prevent reduction in the amount of light irradiated into liquid crystal display panel 2.

Also, in the present embodiment, as described above, heat dissipating tape 6c having heat dissipating functions as well as adhesive functions for the purpose of attaching the other surface of LED (the surface in the direction of arrow X2) is placed between the other surface of LED board 6b and bottom part 10b of heat sink 10. By this means, it is possible to dissipate heat transferred from LEDs 6a through LED board 6b, and at the same time to affix the other surface of LED board 6b to side part 10b of heat sink 10 using heat dissipating tape 6c.

In addition, in the present embodiment, as described above, claw parts 10*l* extending along the side of LED board 6b (the side of the direction of arrow X1) are placed at the ends of the side of side part 10b (the side in the direction of arrow Y1) opposite bottom part 10c in the part corresponding to release parts 10k, and claw parts 10*l* and LED board 6b are separated by a specified distance D1. By this means, it is possible to prevent heat sink 10 from separating from LED board 6b, using claw parts 10*l*. Also, by separating claw parts 10*l* and LED board 6b by designated distance D1, it is possible to prevent LED board 6b from contacting bended part 10m between claw par 10*l* and side part 10b. By this means, it is possible to prevent LED board 6b from becoming fixed in a slanted direction with respect to side part 10b as a result of contact with bended part 10m between claw par 10*l* and side part 10b, and thereby it is possible to further prevent LED board 6b from becoming fixed at a slanting angle with respect to side part 10b. As a result, by further preventing light from LEDs 6a from being emitted at angles deviating from the intended direction of emission (the direction perpendicular to side part 10b or heat sink 10 (the direction of arrow X1)), it is possible to further prevent reduction in the amount of light irradiated into liquid crystal display panel 2.

Also, in the present embodiment, as described above, five board supporting parts 10n are placed at designated intervals along the direction in which LED board 6b extends (the Z direction). By this means, it is possible to support LED board 6b in a stable manner, and at the same time to further prevent LED board 6b from contacting bended part 10g between side part 10b and bottom part 10c by means of five board supporting parts 10n.

In addition, in the present embodiment, as described above, heat sink 10 is configured of sheet shaped material of metal (sheet metal containing aluminum) as one unit containing side part 10b, bottom part 10c, bended part 10g and release parts 10k. By this means, it is possible to prevent increase in number of components, as compared with placing side part 10b, bottom part 10c, bended part 10g, and release parts 10k each on heat sink 10 as separate components. And by using sheet shaped material of metal, it is possible to easily form release parts 10k such as hole parts 10j by means of a press process etc.

In the embodiment hereby disclosed, all points may be considered examples and not limiting.

For example, in the aforementioned embodiment, the present invention is stated as a display device, using an example of an application to an LCD television device. However, the present invention is not limited thereto. The present invention may be applied to other display devices such as PC (personal computer) monitors, etc.

Also, the aforementioned embodiment is described using an example whereby release parts 10k are formed by removing a part of bended part 10g (a part bent by folding) so as to provide holes 10j in the ends on the bottom part 10c side of side part 10b of heat sink 10 (the heat dissipating material). However, the present invention is not limited thereto. In the present invention it is also possible to form a release part without placing holes in the side parts of the heat dissipating material, by removing the bended part and placing holes in the ends of the sides of the side parts of the bottom part of the heat dissipating material. Also, in the present invention, the release parts may also be formed by eliminating the entire inner surface of the bended part and placing grooves (trenches) along the direction in which the LED board extends, rather than eliminating a part of the bended part and placing holes.

In addition, in the aforementioned present embodiment, board supporting parts 10n are described as formed in a flat planar shape protruding on the side of LED board 6b (the light emitting element board), however the present invention is not limited thereby. In the present invention, the board supporting parts may also be formed in the shape of a curved surface, or in a projecting shape, protruding on the side of the light emitting element board.

Also, in the aforementioned embodiment, an example is described whereby LED board 6b (the light emitting element board) is mounted on side part 10b of heat sink 10 (the heat dissipating material) using heat dissipating tape 6c having an adhesive function as well as a heat dissipating function, however the present invention is not limited thereby. In the present invention, the light emitting element board may be attached to the side part of the heat dissipating material using material other than heat dissipating tape (such as adhesive bond). Also, the light emitting element board may be attached directly to the side part of the heat dissipating material without using heat dissipating tape, etc.

In addition, the aforementioned embodiment describes an example whereby five release parts 10k are placed along the direction in which LED board 6b (the light emitting element board) extends, however the present invention is not limited thereby. In the present invention, it is also possible to make the number of release parts 10k be four or fewer, as well as six or greater.

### Explanation of Reference Numbers

2... liquid crystal cell (display part)
6a... LED (light emitting element)
6b... LED board (light emitting element board)
6c... heat dissipating tape
10... heat sink (heat dissipating material)
10b.. side part
10c.. bottom part
10g... bended part
10j... hole part
10k... release part
10l... claw part
10n... board supporting part
10o ... cutout part
18... tuner (receiving part)
100... liquid crystal television device (display device, television device)

## Claims

1. A display device (100), comprising:
a display part (2);
a light emitting element (6a) that shines light into the display part (2);
a light emitting element board (6b) with the light emitting element (6a) fixed on one side;
a heat dissipating material (10) formed by bending a sheet material made of metal so as to comprise:
a first plane attached to an other side of the light emitting element board (6b), and
a second plane that forms a specified angle with respect to the first plane and has a heat dissipation function to dissipate heat from the light emitting element (6a),
wherein the heat dissipating material includes a release part (10k) formed by removing a bended part (10g) that is the boundary of the first plane and the second plane, and
a board supporting part (10n) formed in an area corresponding to the release part (10k) in the second plane and protruding toward the light emitting element board (6b) so as to contact the light emitting element board (6b).

2. The display device (100) according to claim 1, wherein the release part (10k) is formed by removing a part of the bended part (10g) and forming a hole part (10j) in at least the first plane of the heat dissipating material (10).

3. The display device according to claim 2, wherein the board supporting part (10n) is positioned in an area corresponding to the hole part (10j) and is formed in a flat plane shape protruding more toward the light emitting element board (6b) than the second plane positioned in an area other than an area corresponding to the hole part (10j).

4. The display device (100) corresponding to claim 2 or claim 3, wherein
the heat dissipating material (10) includes a pair of cutout parts (10o) placed in
the second plane so as to extend from both end parts of the hole part (10j) along a direction perpendicular to a direction of the light emitting element board (6b), and
the board supporting part (10n) is formed such that the second plane, positioned
in an area surrounded by the hole part (10j) and the pair of cutout parts (10o), protrudes on the side of the light emitting element board (6b).

5. The display device (100) according to any of claims 2-4, wherein a length of the board supporting part (10n) along a direction in which the light emitting board (6b) extends is greater than a length of the light emitting element (6a) in the same direction.

6. The display device (100) according to any of claims 1-5, further comprising a heat dissipating tape (6c) placed between the other side of the light emitting element board (6b) and the first plane of the heat dissipating material (10) and having a heat dissipating function and a bonding function to attach the other side of the light emitting element board (6b) to the first plane of the heat dissipating material (10).

7. The display device (100) according to any of claims 1-6, wherein a claw part (101) extending along the side of the light emitting element board (6b) is placed on the end of the side opposite the second plane of the part corresponding to the release part (10k) of the first plane, and the claw part (101) and the light emitting element board (6b) are separated by a specified distance.

8. The display device (100) according to any of claims 1-7, wherein a plurality of board supporting parts (10n) are placed separated at specified intervals along the direction in which the light emitting element board (6b) extends.

9. A television device, comprising;
a receiving part (18) that receives television broadcasts;
and a display device (100) according to any of claims 1-8.

## Amended claims

### Amended claims in accordance with Rule 137(2) EPC.

**1.** A display device (100), comprising:
a display part (2);
a light emitting element (6a) configured to shine light into the display part (2);
a light emitting element board (6b) with the light emitting element (6a) fixed on one side;
a heat dissipating material (10) formed by bending a sheet material made of metal so as to comprise:
a first plane attached to another side of the light emitting element board (6b), and a second plane that forms a specified angle with respect to the first plane and has a heat dissipation function to dissipate heat from the light emitting element (6a),
wherein the heat dissipating material (10) includes a release part (10k) formed by removing a bended part (10g) that is the boundary of the first plane and the second plane, and a board supporting part (10n) formed in an area corresponding to the release part (10k) in the second plane and protruding toward the light emitting element board (6b) so as to contact the light emitting element board (6b).

**2.** The display device (100) according to claim 1, wherein the release part (10k) is formed by removing a part of the bended part (10g) and forming a hole part (10j) in at least the first plane of the heat dissipating material (10).

**3.** The display device according to claim 2, wherein the board supporting part (10n) is positioned in an area corresponding to the hole part (10j) and is formed in a flat plane shape protruding more toward the light emitting element board (6b) than the second plane positioned in an area other than an area corresponding to the hole part (10j).

**4.** The display device (100) corresponding to claim 2 or claim 3, wherein
the heat dissipating material (10) includes a pair of cutout parts (10o) placed in the second plane so as to extend from both end parts of the hole part (10j) along a direction perpendicular to a direction of the light emitting element board (6b), and the board supporting part (10n) is formed such that the second plane, positioned in an area surrounded by the hole part (10j) and the pair of cutout parts (10o), protrudes on the side of the light emitting element board (6b).

**5.** The display device (100) according to any of claims 2-4, wherein a length of the board supporting part (10n) along a direction in which the light emitting board (6b) extends is greater than a length of the light emitting element (6a) in the same direction.

**6.** The display device (100) according to any of claims 1-5, further comprising a heat dissipating tape (6c) placed between the other side of the light emitting element board (6b) and the first plane of the heat dissipating material (10) and having a heat dissipating function and a bonding function to attach the other side of the light emitting element board (6b) to the first plane of the heat dissipating material (10).

**7.** The display device (100) according to any of claims 1-6, wherein a claw part (101) extending along the side of the light emitting element board (6b) is placed on the end of the side opposite the second plane of the part corresponding to the release part (10k) of the first plane, and the claw part (101) and the light emitting element board (6b) are separated by a specified distance.

**8.** The display device (100) according to any of claims 1-7, wherein a plurality of board supporting parts (10n) are placed separated at specified intervals along the direction in which the light emitting element board (6b) extends.

**9.** A television device, comprising;
a receiving part (18) that receives television broadcasts;
and a display device (100) according to any of claims 1-8.
